# DEMANDE DE BREVET EUROPEEN

(11) **EP 4 845 373 A1**
(43) Date de publication de la demande: **25.11.2026**
(21) Numéro de dépôt: 26179609.8
(22) Date de dépôt: 19.05.2026
(51) Int. Cl.: H10N 60/80, H10N 60/01, H10W 20/20

(54) **STRUCTURE D'INTERCONNEXION DE TYPE VIA SUPRACONDUCTEUR**

(30) Priorité: 21.05.2025 FR 2505471
(71) Demandeur: Commissariat à l'Energie Atomique et aux Energies Alternatives, 75015 Paris (FR)
(72) Inventeur: CHARBONNIER, Jean, 38054 Grenoble Cedex 09 (FR); PELLISSIER, Catherine, 38054 Grenoble Cedex 09 (FR); DESCHASEAUX, Edouard, 38054 Grenoble Cedex 09 (FR)
(74) Mandataire: Atout PI Laplace

(57) **Abrégé**

Une structure d'interconnexion de type via supraconducteur (1), comprend :
- un substrat (2) définissant une face avant (3) et une face arrière (4) ;
- au moins un trou (5) qui s'étend au moins sur une partie de la profondeur du substrat, depuis une ouverture du côté de la face arrière (4) ;
- une couche supraconductrice (7) qui recouvre au moins une partie du substrat sur la face arrière, ainsi que le trou (5) au niveau du flanc (13) et au niveau du fond (14) du trou (5) ;
- une couche métallique non-supraconductrice (8) qui recouvre la couche supraconductrice (7),
l'épaisseur de la couche supraconductrice (7) étant déterminée en fonction des propriétés supraconductrices du couple formé par le matériau de la couche supraconductrice (7) et par le matériau de la couche métallique non-supraconductrice (8), de façon à ce que toute la conduction à travers la structure d'interconnexion se fasse par la couche supraconductrice (7).

## Description

L'invention se rapporte à une structure d'interconnexion de type via supraconducteur, ainsi qu'à un procédé de fabrication d'une structure d'interconnexion de type via supraconducteur. L'invention trouve son application dans le domaine des architectures de circuits quantiques et plus largement les circuits cryogéniques comme les détecteurs pour l'astrophysique.

Dans l'industrie des semi-conducteurs, un via traversant (ou TSV pour « Through-Silicon Via » en anglais) est un contact électrique vertical traversant un substrat en silicium, reliant ainsi ses deux faces. Il s'agit donc d'un trou métallisé, qui permet de récupérer les connexions sur la face opposée à la face active, où sont situés les modules microélectroniques.

L'intérêt principal des vias traversants est de permettre l'interconnexion d'une puce avec une autre ou avec un substrat sans utiliser de câblage par fil, offrant ainsi une connexion plus compacte, plus robuste et avec des résistances et des inductances d'accès réduites.

Dans des applications telles que les ordinateurs quantiques, ou dans certains capteurs ultrasensibles, la présence de matériaux supraconducteurs est essentielle pour obtenir les effets quantiques spécifiques à l'échelle nanométrique et/ou afin de faire circuler un courant électrique sans aucune résistance électrique.

L'augmentation du nombre de qubits dans les applications précitées nécessite également de concevoir des vias supraconducteurs, c'est-à-dire des vias comportant des matériaux supraconducteurs capables de faire circuler un courant électrique sans aucune résistance électrique.

Pour autant, les procédés de fabrication des vias dans l'industrie des semi-conducteurs ne sont pas transposables à la fabrication de vias supraconducteurs. Le document EP 2 608 253 A2 décrit un exemple de structure de via TSV utilisable dans des circuits intégrés 3D, mais non compatible avec des matériaux supraconducteurs. En effet, la présence d'un trou de grande dimension en face avant est incompatible avec la réalisation de dispositif de type jonction Josephson qui nécessite une lithographie avec une résine résolue à l'échelle du micron.

Différentes solutions sont connues pour fabriquer des vias supraconducteurs susceptibles de conduire des courants critiques de plusieurs milliampères.

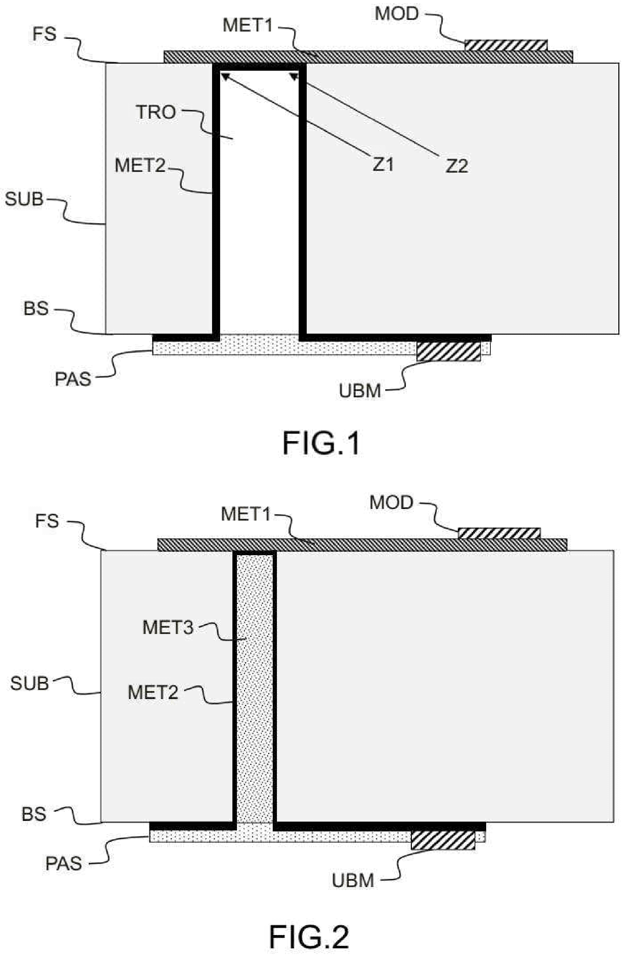

Une première solution est illustrée par la figure 1. Un substrat SUB en silicium comprend une face avant FS sur laquelle se trouve une couche de matériau supraconducteur MET1, par exemple du Niobium, connectée à un module supraconducteur MOD, par exemple une puce ou un ensemble de qubits. Le substrat SUB comprend une face arrière BS, par laquelle un trou TRO est effectué qui débouche sur la couche de matériau supraconducteur MET1. Une métallisation MET2 de type liner LIN, avec un matériau supraconducteur (par exemple un alliage TiN/Nb) est appliquée dans le trou TRO, sur l'intégralité de la paroi verticale, et au fond du trou. Une couche de passivation PAS protège la face arrière, et un élément de contact (par exemple un UBM pour « Under Bump Metallurgy ») assure la compatibilité entre la métallisation de la face arrière BS de la puce et celle du niveau inférieur.

Le fond du trou, en contact avec le matériau supraconducteur MET de la face avant, est également appelé « membrane ». La membrane a typiquement une épaisseur comprise entre quelques nm et 1 µm, le trou TRO ayant un diamètre compris entre 40 et 60 µm.

Avec la première solution, la membrane est fragile, en raison de la faible tenue mécanique au niveau des zones angulaires Z1 et Z2, c'est-à-dire à la jonction entre la paroi verticale et la membrane. En effet, lors du refroidissement (à la fin du procédé de fabrication) et lors de l'utilisation à température cryogénique, il y a un risque que la membrane se casse en raison de la différence de coefficients de dilatation entre la couche de matériau supraconducteur MET1, la métallisation MET2 et le substrat SUB.

Une deuxième solution, illustrée par la figure 2, consiste à remplir le trou avec un matériau de remplissage d'un métal non-supraconducteur MET3, par exemple du cuivre. Cette solution évite de fragiliser la membrane. Toutefois, lorsque le diamètre du trou est supérieur à 30 µm, le remplissage avec le métal non-supraconducteur MET3 n'est plus possible. Ainsi, le diamètre du trou ne dépasse pas 15 µm, ce qui aboutit à un facteur de forme très « agressif » (de l'ordre de 10 :1).

Par ailleurs, en raison de la faible épaisseur du métal supraconducteur MET2 sur les flancs et de la présence de cuivre, l'effet de proximité inverse réduit considérablement les propriétés supraconductrices du via.

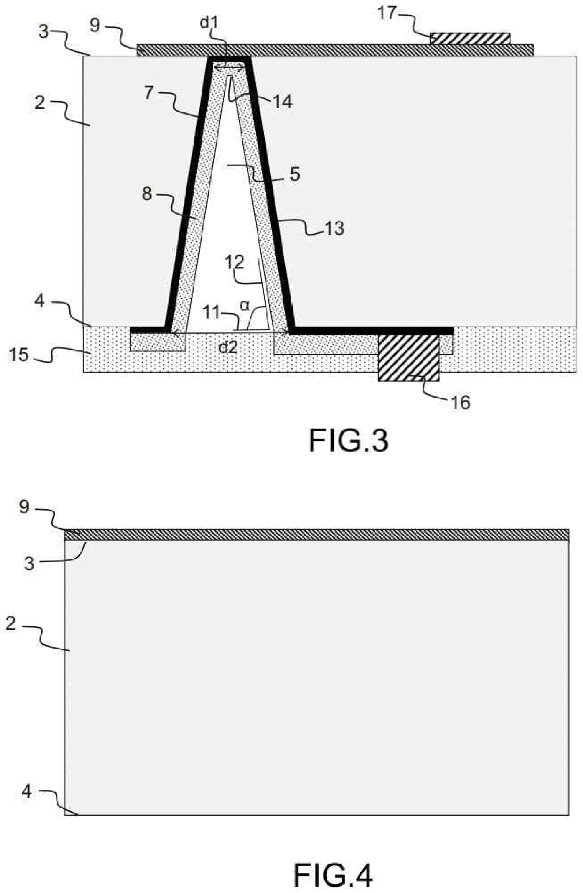

L'article de [Vahidpour] décrit un TSV supraconducteur pour des circuits intégrés quantiques. La figure 3 de l'article illustre les étapes du procédé de fabrication du via. A la suite de la gravure du via (via incliné), une couche d'aluminium est déposée par évaporation par faisceau d'électrons. Une couche de passivation en polymère est ensuite déposée par dépôt physique en phase gazeuse, pour éviter une oxydation de la couche supraconductrice en aluminium. Un plot de contact est ajouté en fin de processus, en contact avec la couche de polymère.

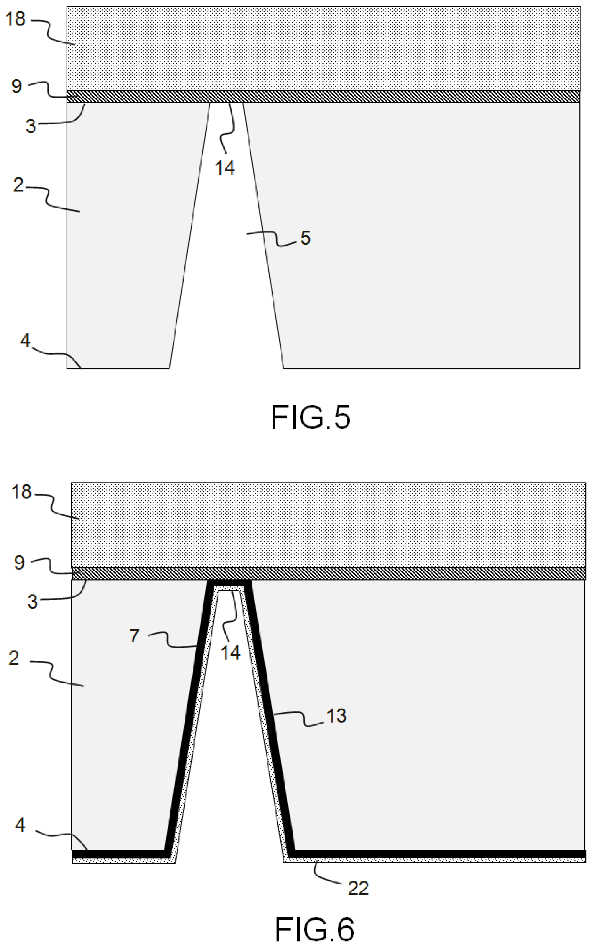

Il apparaît, sur les figures 5 et 6 de l'article de [Vahidpour], que l'épaisseur du plot de contact est très faible (quelques dizaines de nanomètres), ce qui rend la structure très fragile, et le courant critique (valeur à ne pas dépasser), est de l'ordre de la centaine de microampères, l'aluminium ne permettant pas d'atteindre des courants critiques plus élevés.

La présente invention vise donc à fournir une structure d'interconnexion de type via supraconducteur, disposant d'une bonne tenue mécanique, et capable de supporter des courants critiques élevés (de l'ordre de 5 mA).

### Résumé de l'invention

Un objet de l'invention est donc une structure d'interconnexion de type via supraconducteur, comprenant :
- un substrat définissant une face avant et une face arrière ;
- au moins un trou qui s'étend au moins sur une partie de la profondeur du substrat, depuis une ouverture du côté de la face arrière ;
- une couche supraconductrice qui recouvre au moins une partie du substrat sur la face arrière, ainsi que le trou au niveau du flanc et au niveau du fond du trou ;
   la structure d'interconnexion comprend également une couche métallique non-supraconductrice qui recouvre la couche supraconductrice, l'épaisseur de la couche supraconductrice étant déterminée en fonction des propriétés supraconductrices du couple formé par le matériau de la couche supraconductrice et par le matériau de la couche métallique non-supraconductrice, de façon à ce que toute la conduction à travers la structure d'interconnexion se fasse par la couche supraconductrice.

Avantageusement, un plan de routage supraconducteur est déposé sur la face avant, le trou s'étendant sur toute la profondeur du substrat, jusqu'à atteindre le plan de routage supraconducteur, définissant une membrane correspondant à la surface de la couche supraconductrice en contact direct avec le plan de routage supraconducteur.

Avantageusement, le diamètre de la membrane est inférieur au diamètre du trou au niveau de la face arrière, définissant ainsi une pente ayant un angle prédéterminé, l'angle étant défini par rapport à une première droite parallèle à la face avant et à une deuxième droite parallèle au flanc.

Avantageusement, l'angle est compris entre 70° et 80°.

Avantageusement, la structure comprend deux trous, le trou étant appelé « premier trou », et la couche supraconductrice qui recouvre le premier trou étant appelée « première couche supraconductrice », dans laquelle un deuxième trou s'étend depuis la face avant, le premier trou et le deuxième trou étant agencés de façon à ce qu'ils soient alignés selon la profondeur du substrat, une deuxième couche supraconductrice recouvrant au moins une partie du substrat sur la face avant, ainsi que le flanc et le fond du deuxième trou.

L'invention se rapporte également à un procédé de fabrication d'une structure d'interconnexion de type via supraconducteur, le procédé comprenant des étapes de :
S1 : fourniture d'un substrat définissant une face avant et une face arrière ;
S2 : structuration d'un trou par la face arrière du substrat, au moins sur une partie de la profondeur du substrat ;
S3 : dépôt d'une couche supraconductrice qui recouvre au moins une partie du substrat sur la face arrière, ainsi que le trou au niveau du flanc et au niveau du fond du trou ;
S4 : dépôt d'une couche métallique non-supraconductrice sur la couche supraconductrice, l'épaisseur de la couche supraconductrice étant déterminée en fonction des propriétés supraconductrices du couple formé par le matériau de la couche supraconductrice et par le matériau de la couche métallique non-supraconductrice, de façon à ce que toute la conduction à travers la structure d'interconnexion se fasse par la couche supraconductrice.

Avantageusement, le procédé comprend :
- entre les étapes S1 et S2, un dépôt d'un plan de routage supraconducteur sur la face avant, et une étape de collage d'une première poignée temporaire sur le plan de routage supraconducteur ;
- dans l'étape S2, structuration du trou sur toute la profondeur du substrat, jusqu'à ce que le fond du trou débouche sur le plan de routage supraconducteur ;

Le procédé comprenant, à la suite de l'étape S4, les étapes suivantes :
- S5 : passivation de la face arrière de façon à obtenir une couche de passivation, et structuration de la face arrière de façon à accueillir au moins un dispositif de connexion électrique ;
- S6 : collage d'une deuxième poignée temporaire sur la couche de passivation ;
- S7 : retrait de la première poignée temporaire ;
- S8 : structuration de la face avant de façon à accueillir au moins un module électronique supraconducteur sur le plan de routage supraconducteur ;
- S9 : retrait de la deuxième poignée temporaire.

Avantageusement, le procédé comprend, entre les étapes S3 et S4, une étape de dépôt d'une couche de construction sur la couche supraconductrice, pour y effectuer une croissance électrolytique.

Avantageusement, l'étape S3 comprend un dépôt électrochimique de la couche métallique non-supraconductrice.

Avantageusement, la couche métallique non-supraconductrice est utilisée comme masque dur dans une étape de gravure de la face arrière, entre les étapes S4 et S5.

Avantageusement, la première poignée temporaire est collée par collage moléculaire, la première poignée temporaire étant retirée par abrasion puis par gravure humide avec arrêt sélectif au niveau du plan de routage supraconducteur.

Avantageusement, la deuxième poignée temporaire est collée avec une colle polymère, la deuxième poignée temporaire étant retirée par décollement mécanique ou par traitement UV.

Avantageusement, le procédé comprend :
- dans l'étape S2, une structuration du trou sur une partie de la profondeur du substrat, le trou étant appelé « premier trou » ;
   le procédé comprend, à la suite de l'étape S4, les étapes suivantes :
   - S5' : dépôt d'une couche de passivation sur la face arrière ;
   - S6' : collage d'une poignée temporaire sur la couche de passivation ;
   - S7' : structuration d'un deuxième trou par la face avant du substrat, le premier trou et le deuxième trou étant agencés de façon à ce qu'ils soient alignés selon la profondeur du substrat :
   - S8' : métallisation de la face avant et du deuxième trou, avec une deuxième couche supraconductrice ;
   - S9' : structuration de la face avant de façon à accueillir au moins un module électronique supraconducteur ;
   - S10' : retrait de la poignée temporaire.

Avantageusement, la profondeur du premier trou et la profondeur du deuxième trou sont identiques.

Avantageusement, le diamètre du fond du deuxième trou est inférieur au diamètre du fond du premier trou.

Avantageusement, le procédé comprend, entre les étapes S8' et S9', une étape S10' de dépôt d'un opercule de protection à l'entrée du deuxième trou.

### Description des figures

D'autres caractéristiques, détails et avantages de l'invention ressortiront à la lecture de la description faite en référence aux dessins annexés donnés à titre d'exemple.
Les figures 1 et 2 illustrent des vias supraconducteurs selon l'état de la technique.
La figure 3 illustre une structure d'interconnexion de type via supraconducteur, selon un premier mode de réalisation.
Les figures 4 à 17 illustrent les différentes étapes de fabrication de la structure d'interconnexion de type via supraconducteur, selon le premier mode de réalisation.
La figure 18 illustre une structure d'interconnexion de type via supraconducteur, selon un deuxième mode de réalisation.
Les figures 19 à 33 illustrent les différentes étapes de fabrication de la structure d'interconnexion de type via supraconducteur, selon le deuxième mode de réalisation.
La figure 34 illustre, de façon schématique, les différentes étapes du procédé de fabrication de la structure d'interconnexion, selon le premier mode de réalisation et selon le deuxième mode de réalisation.

### Description détaillée

La figure 3 illustre un premier mode de réalisation du via traversant supraconducteur selon l'invention.

La structure d'interconnexion comprend un substrat 2, qui peut être constitué d'une plaque de silicium, ou de tout autre matériau semi-conducteur, et qui sert de support structurel et électrique aux circuits. Le substrat 2 permet ainsi d'établir des connexions entre les différentes couches d'un dispositif en intégration 3D, en faisant passer les signaux d'une face arrière 4 à une face avant 3, ou réciproquement, grâce au trou 5 qui est fait dans le substrat.

La face avant 3 peut comprendre des composants actifs 17 tels que des qubits supraconducteurs 17 utilisés dans les ordinateurs quantiques, ou encore des pixels de détecteurs fonctionnant à très basse température, ainsi qu'un ou plusieurs plans de routage supraconducteur (par exemple en niobium). La face arrière sert généralement de point d'entrée/sortie de signaux venant d'une autre puce ou d'un autre substrat.

La structure d'interconnexion comprend également un trou 5 créé depuis la face arrière 4, et qui est creusé dans toute la profondeur du substrat, jusqu'à la face avant 3. Une couche supraconductrice 7 est déposée sur les flancs du trou 5 (c'est-à-dire la paroi verticale) et au fond 14 du trou. Par exemple, la couche supraconductrice 7 peut être composée de TiN, de Nb ou d'un empilement des deux matériaux. D'autres matériaux supraconducteurs peuvent être envisagés, par exemple le NbN, qui pourrait être utilisé seul, ou en combinaison avec le TiN et/ou avec le Nb.

Le via agit ainsi comme un conducteur vertical qui relie directement les couches de routage de la face arrière aux couches de routage de la face avant. En effet, lorsqu'un signal électrique est appliqué à l'entrée du via, à partir du point de connexion 16 (par exemple un point de connexion de type UBM pour « Under Bump Metallurgy »), la conduction s'effectue à travers le substrat, grâce à la couche supraconductrice 7.

La structure selon l'invention comprend avantageusement une couche métallique non-supraconductrice 8 qui recouvre la couche supraconductrice 7 en tout point, c'est-à-dire au niveau de la face arrière 4, sous la couche de passivation 15, mais également sur les flancs du trou et au fond du trou. Par exemple, la couche métallique non-supraconductrice 8 peut être du cuivre, qui est un métal pour lequel la technique de dépôt électrolytique est bien maîtrisée, avec un coût réduit. Toutefois, d'autres métaux peuvent être utilisés, comme l'or, par exemple.

L'épaisseur de la couche supraconductrice 7 est déterminée en fonction des propriétés supraconductrices du couple formé par le matériau de la couche supraconductrice 7 et par le matériau de la couche métallique non-supraconductrice 8, de façon à ce que toute la conduction à travers la structure d'interconnexion se fasse par la couche supraconductrice. Plus précisément, l'épaisseur minimum de la couche supraconductrice 7 est telle que l'effet de proximité inverse dû au contact avec la couche métallique non-supraconductrice 8 soit annulé.

Pour rappel, l'effet de proximité inverse désigne la suppression de la supraconductivité dans un matériau supraconducteur (S) au contact d'un matériau normal (non supraconducteur, N), due au transfert de paires de Cooper vers le matériau normal.

En effet, il a été constaté qu'à partir d'une certaine épaisseur de la couche supraconductrice 7 (liée à la longueur de cohérence du supraconducteur), celui-ci devient insensible à la présence du métal non-supraconducteur au-dessus. Ainsi, en déterminant une épaisseur minimale de la couche supraconductrice 7 en fonction des propriétés supraconductrices du couple formé par le matériau de la couche supraconductrice 7 et par le matériau de la couche métallique non-supraconductrice 8, la couche métallique non-supraconductrice 8 ne sert plus de conducteur, mais uniquement de renfort mécanique. Par conséquent, toute la conduction électrique a lieu par la couche supraconductrice 7.

Il est rappelé que la longueur de cohérence d'un matériau supraconducteur correspond à la longueur fondamentale qui régit la taille des paires de Cooper grâce auxquelles le matériau possède une résistance nulle. Par exemple, la longueur de cohérence est égale à 10,7 nm pour le Nb, 10,1 nm pour le TiN, et 1,9 nm pour le NbN. Plus la longueur de cohérence est élevée, plus la couche de supraconducteur devra être épaisse afin d'obtenir l'effet souhaité. D'autres valeurs peuvent être extraites de l'article de [Thomas].

Avantageusement, mais non nécessairement, les flancs du via sont en pente. Ainsi le diamètre d1 de la membrane, qui correspond à la partie 10 de la couche supraconductrice 7 située au fond 14 du trou 5, est inférieur au diamètre d2 du trou 5 au niveau de la face arrière 4. Une première droite 11 parallèle à la face avant 3, et une deuxième droite 12 parallèle au flanc 13 définissent ainsi un angle prédéterminé α.

Le fait que les flancs du via soient en pente améliore la conformité du dépôt de la couche supraconductrice 7, et améliore ainsi la capacité de la couche supraconductrice 7 à épouser parfaitement le trou et à transmettre plus de courant. De plus, plus la membrane est petite, moins les contraintes mécaniques liées à la tenue de la membrane sont élevées. Il est rappelé que la conformité est définie par le rapport entre l'épaisseur déposée au fond du trou et l'épaisseur de la couche supraconductrice 7 au niveau de la face arrière.

Un angle α est défini par rapport à une première droite 11 parallèle à la face avant 3 et à une deuxième droite 12 parallèle au flanc 13.

Selon un mode de réalisation préférentiel, l'angle α est compris entre 70° et 80°. En effet, la profondeur du substrat doit être comprise entre 100 et 200 µm (contrainte technologique des substrats en silicium). Le diamètre souhaité pour la membrane est égal à 5 µm, ce qui permet de faire circuler un courant critique de l'ordre de 5 mA. Un angle compris entre 70° et 80° permet d'obtenir un diamètre d2 de face arrière compris entre 60 et 80 µm, ce qui est compatible avec les contraintes d'espacement des vias au niveau de la face arrière.

Par exemple, si on souhaite avoir une membrane de 5 µm de diamètre (diamètre d1), une profondeur de 120 µm, et un diamètre d2 de face arrière égal à 60 µm, la valeur de l'angle α doit être égale à 77°.

Selon un autre exemple, si on souhaite avoir une membrane de 5 µm de diamètre (diamètre d1), une profondeur de 200 µm, et un diamètre d2 de face arrière égal à 60 µm, la valeur de l'angle α doit être égale à 76°.

Selon un autre exemple, si on souhaite avoir une membrane de 5 µm de diamètre (diamètre d1), une profondeur de 120 µm, et un diamètre d2 de face arrière égal à 80 µm, la valeur de l'angle α doit être égale à 72°.

Ces trois exemples illustrent le fait qu'en choisissant un angle compris entre 70° et 80°, une grande étendue de valeurs de profondeur et de diamètre face arrière peut être couverte.

Les basses températures, typiquement inférieures à 10 K, permettent de piéger les porteurs de charge dans le substrat en silicium. Ainsi, la structure d'interconnexion permet, de façon avantageuse, de se passer d'une étape qui viserait à déposer un oxyde de silicium sur les flancs du via, afin d'éviter les pertes RF dans le substrat diélectrique. Le dépôt de l'oxyde de silicium est généralement obtenu par un processus dit de SACVD (« Sub-Atmospheric Chemical Vapor Deposition »), et permet d'isoler électriquement les vias entre eux. Le processus de SACVD est relativement compliqué à mettre en œuvre.

Les figures 4 à 17 illustrent les différentes étapes de la fabrication du système d'interconnexion selon le premier mode de réalisation correspondant au schéma de la figure 3.

Le procédé comprend la fourniture d'un substrat 2 définissant une face avant 3 et une face arrière 4 (étape S1, figure 4). La face avant du substrat désigne ainsi la surface sur laquelle sont formés les modules actifs supraconducteurs (par exemple les puces de qubits, ou les pixels d'un capteur), tandis que la face arrière correspond à la face opposée.

Un plan de routage supraconducteur 9 est ensuite déposé sur la face avant, par exemple du niobium ; une couche d'encapsulation (non visible sur la figure), par exemple en TiN, permet de protéger le plan de routage supraconducteur vis-à-vis de l'environnement extérieur. Avantageusement une couche d'encapsulation est également située entre le plan de routage supraconducteur 9 et le substrat, ayant ainsi une fonction de couche d'arrêt à la gravure sèche du via par la face arrière.

Une couche d'arrêt (par exemple en dioxyde de silicium), non représentée sur la figure, peut également être déposée sur la couche d'encapsulation.

La figure 5 illustre une étape de collage d'une première poignée temporaire 18, directement sur le plan de routage supraconducteur. La première poignée temporaire 18 peut être en silicium. Il est avantageux que le collage puisse résister à des températures élevées liées au dépôt ultérieur de la couche supraconductrice 7 qui recouvre le trou (environ 400 °C). Le collage moléculaire peut être particulièrement avantageux à cet égard. Il est également possible d'utiliser un collage temporaire avec une colle polymère, plus simple à mettre en place mais limitant à 200 °C les procédés de fabrication des dépôts ultérieurs. Le substrat est éventuellement aminci, par la face arrière.

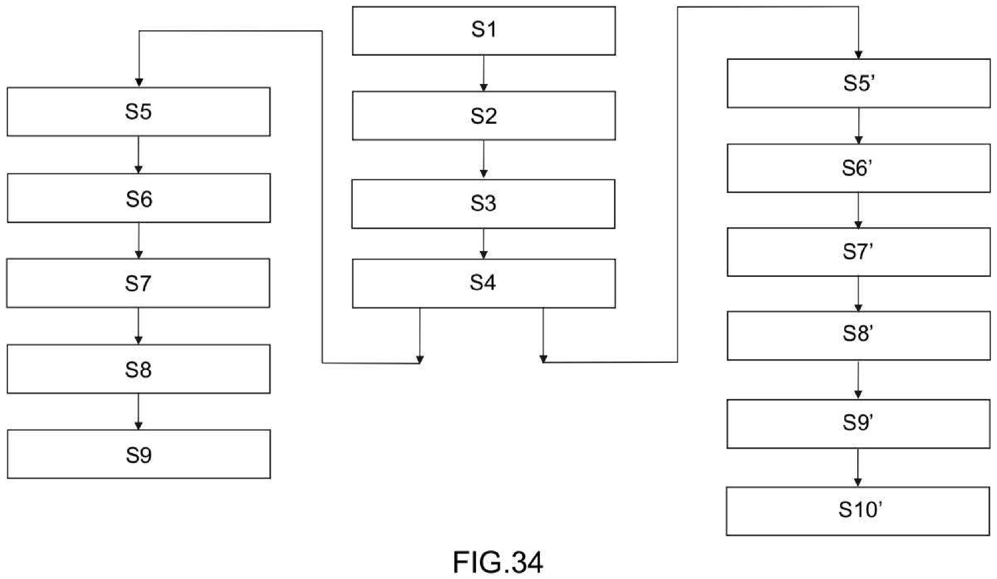

Un trou est ensuite aménagé dans le substrat, par la face arrière, en maintenant le substrat par la première poignée temporaire 18 (étape S2, figure 34). La structuration du trou peut être définie par lithographie. La réalisation du trou peut être effectuée par RIE (pour « Reactive lon Etching ») ou par gravure plasma, ou par tout autre procédé de modification de surface par élimination de matériau. La structuration est effectuée jusqu'à atteindre le plan de routage supraconducteur 9. Le trou peut être en pente, comme cela est illustré sur les figures, sans que cette caractéristique ne soit essentielle. Si le via n'est pas en pente, il peut être préférable d'adapter le process de dépôt, et déposer plus de matière pour un même résultat.

Sur la figure 6, une couche supraconductrice 7 est déposée au niveau du flanc 13 et au niveau du fond 14 du trou, ainsi que sur la face arrière (étape S3, figure 34). Le dépôt peut être effectué par dépôt chimique en phase vapeur (ou CVD pour « Chemical Vapor Deposition ») d'un métal supraconducteur, par exemple du TiN. Le dépôt chimique en phase vapeur permet de générer des revêtements purs d'épaisseur uniforme et de porosité contrôlée, même sur les surfaces complexes ou profilées. Le dépôt chimique en phase vapeur peut être combiné à un dépôt physique en phase vapeur (ou PVD pour « Physical Vapor Deposition ») d'un autre matériau supraconducteur, par exemple du niobium. L'épaisseur cible est égale à 200 nm.

Avantageusement, une couche de construction 22 peut être déposée sur la couche supraconductrice 7, pour y effectuer une croissance électrolytique. Cette couche, également appelée couche de germination, peut être constituée de Ti, de Cu, ou d'un empilement des deux matériaux.

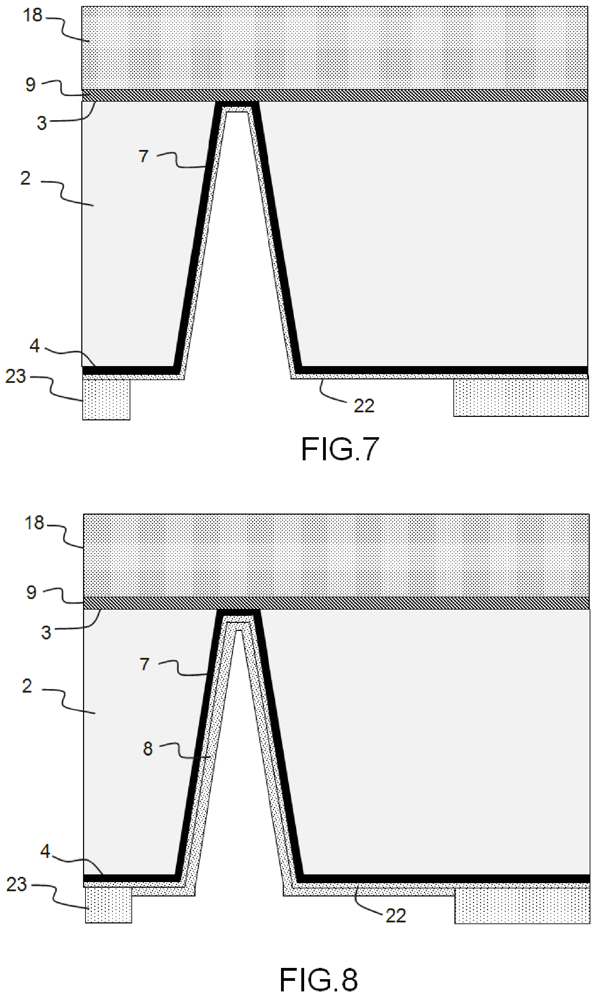

La figure 7 illustre la lithographie de résine sous forme de film sec 23 qui va permettre de faire croitre le cuivre électrolytique dans les zones non protégées par le film 23.

Sur la figure 8, une couche métallique non-supraconductrice 8, par exemple du cuivre, est déposée sur les flancs du trou, au fond du trou, ainsi que sur la face arrière, à l'exception des emplacements occupés par le film sec 23. La couche métallique non-supraconductrice 8 peut être déposée, par exemple, par dépôt électrochimique (ou ECD pour « ElectroChemical Deposition »), qui a l'avantage de procurer un dépôt très conforme (en se référant à la définition précédente de la conformité). L'épaisseur cible est égale à 2 µm, voire plus selon la longueur de cohérence du matériau supraconducteur de la couche supraconductrice. Le dépôt électrochimique de cuivre est une technique bien maitrisée, et peu onéreuse. D'autres métaux peuvent être utilisés, par exemple l'or.

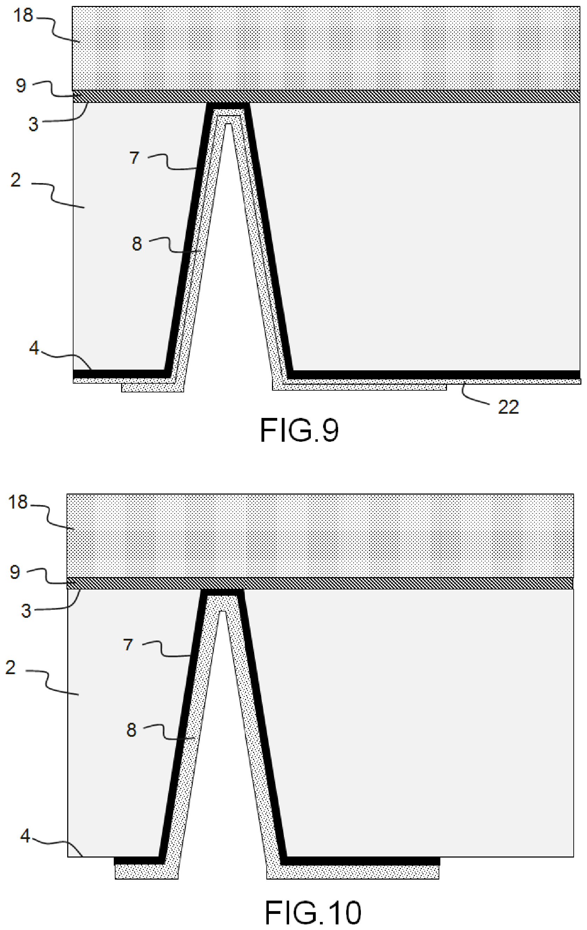

La figure 9 illustre le délaquage (« stripping ») du film sec 23.

Ainsi, la couche métallique non-supraconductrice 8 sert avantageusement de masque dur lors de l'opération de retrait de la couche supraconductrice 7 à l'endroit où se trouvait le film sec 23.

Sur la figure 10, la couche de construction 22 et la couche supraconductrice 7 sont retirées en utilisant la couche métallique non supraconductrice 8 qui sert de masque dur.

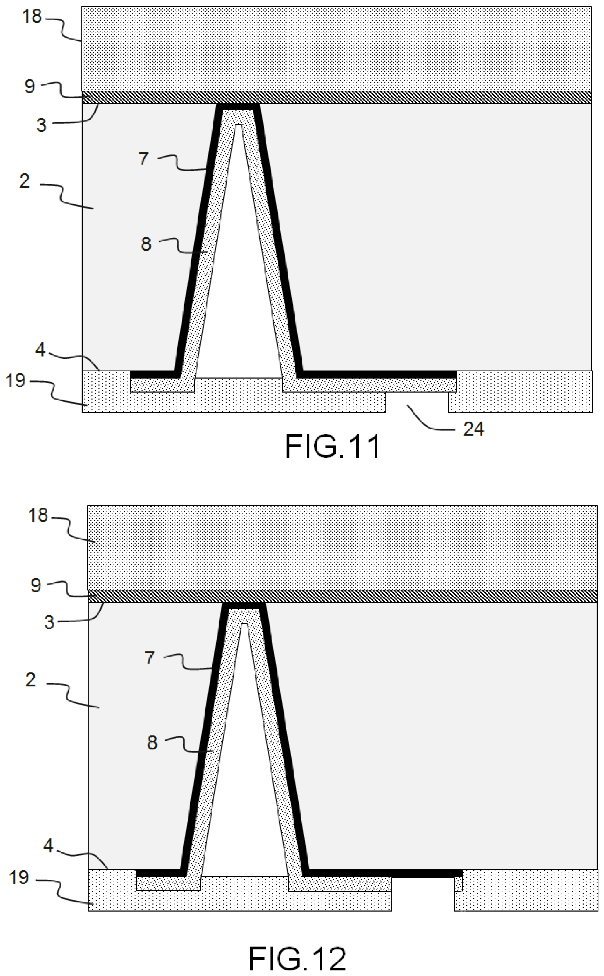

La figure **11** illustre l'étape de passivation de la face arrière, de façon à obtenir une couche de passivation 19 qui protège la face arrière contre la corrosion (étape S5, figure 34). La passivation est structurée de façon à réserver un emplacement 24 pour une métallisation de type UBM pour « Under bump metallization » (ou métallisation sous bille).

La figure 12 illustre la gravure de la couche métallique non-supraconductrice 8 à l'emplacement 24 pour métallisation de type UBM, ce qui permet à la métallisation de type UBM d'être ensuite directement en contact avec la couche supraconductrice 7.

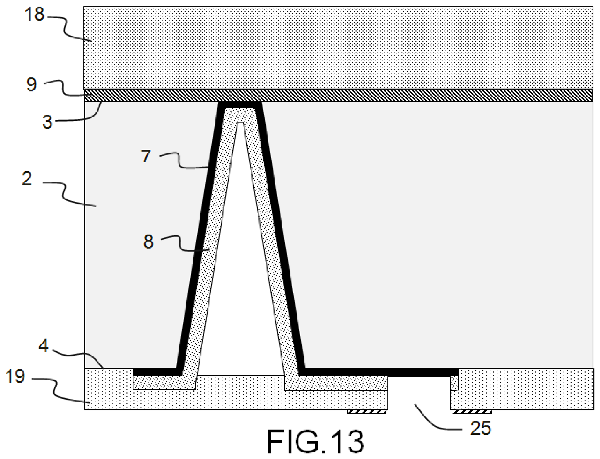

Sur la figure 13, une couche de construction 25 (composée par exemple d'un empilement Ti/Au ; d'une épaisseur typiquement égale à quelques nanomètres) est déposée par PVD pleine plaque suivi d'un patterning (lithographie et gravure), ou par croissance ECD après avoir réalisé une lithographie par résine épaisse) dans l'emplacement 24. Le dépôt de la couche de construction 25 est optionnel.

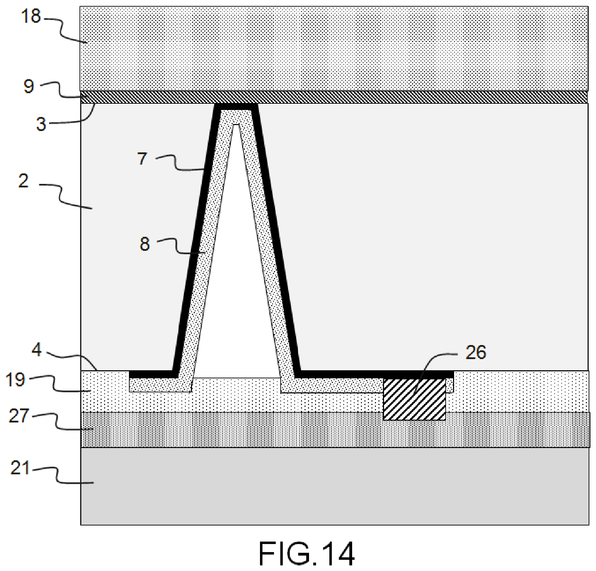

La figure 14 illustre l'ajout de la métallisation de type UBM 26 au niveau de la couche de construction 25. La métallisation de type UBM 26 peut être composée d'une bille d'indium. Ainsi, la liaison entre la face arrière et la face avant est supraconductrice. Par ailleurs, une deuxième poignée temporaire 21 est collée à la couche de passivation 19, une couche de colle 27 permettant ainsi à la deuxième poignée temporaire 21 d'être fixée à la couche de passivation 19 (étape S6, figure 34). La deuxième poignée temporaire 21 peut notamment être en verre ou en silicium. La colle peut être une colle polymère, ou tout autre type de colle susceptible d'être détachée mécaniquement ou par un traitement UV. La couche de passivation 19 peut être composée de polyimide.

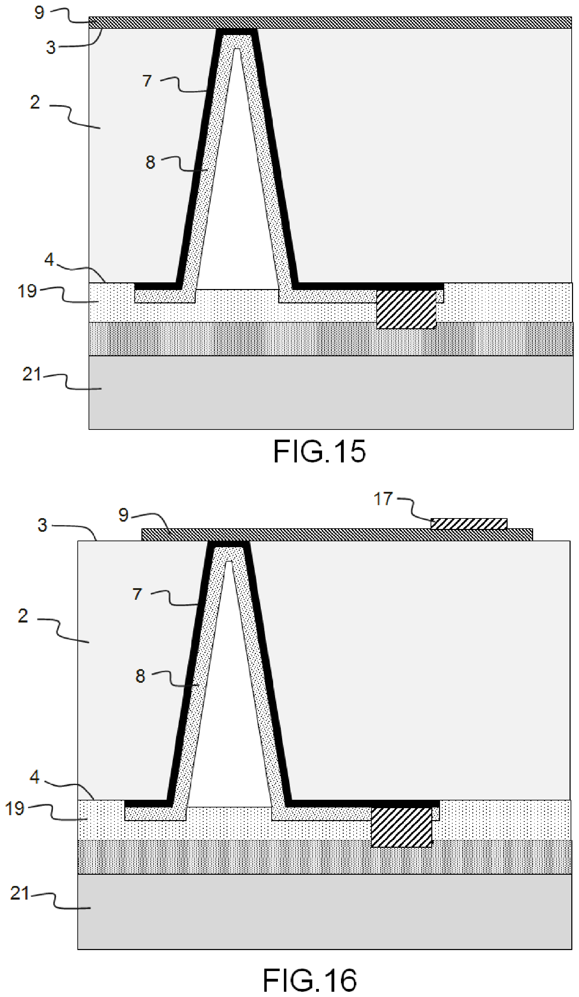

Sur la figure 15, la première poignée temporaire 18 a été retirée (étape S7, figure 34). Le retrait peut être effectué par abrasion, puis gravure humide avec arrêt sélectif au niveau de la couche supraconductrice 7.

La face avant 3 est ensuite structurée de façon à accueillir au moins un module électronique supraconducteur 17 sur le plan de routage supraconducteur 9, comme l'illustre la figure 16 (étape S8, figure 34). Des jonctions Josephson, des résonateurs, des filtres ou tout autre module électronique supraconducteur peuvent ainsi être réalisées sur la face avant. La réalisation de jonctions Josephson nécessite un chauffage au plus à 200 °C ; la colle de la couche de colle 27 doit donc avoir une bonne tenue à cette température (cette température est généralement moins élevée que la température de dépôt de la couche supraconductrice 7).

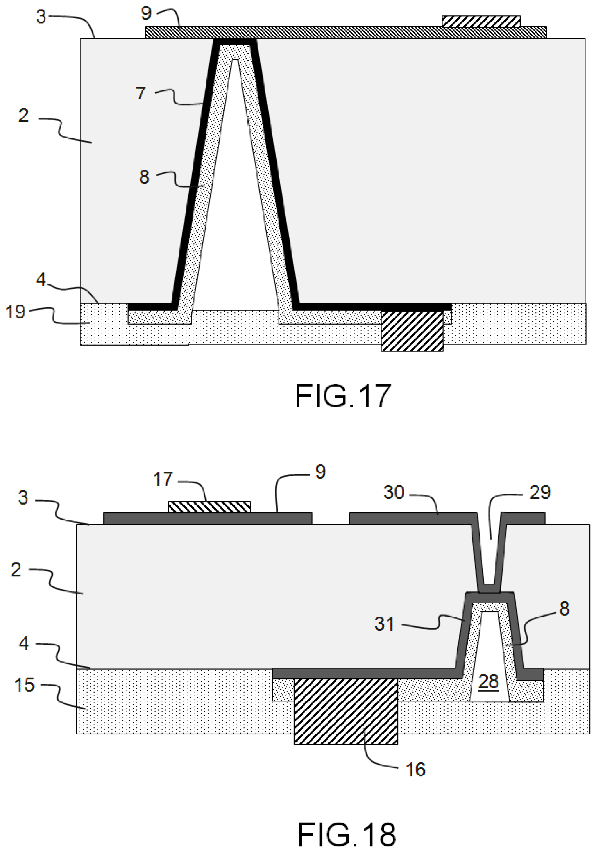

La figure 17 illustre la dernière étape, c'est-à-dire la séparation de la deuxième poignée temporaire 21, soit par détachement aux ultraviolets, soit par séparation mécanique (étape S9, figure 34).

La figure 18 illustre un deuxième mode de réalisation de la structure d'interconnexion selon l'invention. Le deuxième mode de réalisation se distingue essentiellement du premier mode de réalisation en ce que le trou est fait en deux temps, à savoir un premier trou par la face arrière, puis un deuxième trou par la face avant. Le deuxième mode de réalisation permet d'améliorer nettement le facteur de forme de la structure d'interconnexion, défini par le rapport entre la hauteur du trou et le diamètre du côté ouvert du trou.

Selon le deuxième mode de réalisation, la structure d'interconnexion comprend un substrat 2, qui peut être constitué d'une plaque de silicium. La face avant 3 comprend des composants actifs 17, ainsi qu'un plan de routage supraconducteur 9 qui peut être composé de TiN, de Nb ou d'un empilement des deux matériaux. D'autres matériaux supraconducteurs peuvent être envisagés, par exemple le NbN, qui pourrait être utilisé seul, ou en combinaison avec le TiN et/ou avec le Nb.

La structure d'interconnexion comprend un premier trou 28 créé depuis la face arrière 4, et qui est creusé sur une partie de la profondeur du substrat (par exemple jusqu'à la moitié de la profondeur). Une première couche supraconductrice 31 est déposée sur les flancs du premier trou 28, au fond du trou, ainsi que sur une partie de la surface de la face arrière. Par exemple, la première couche supraconductrice 31 peut être composée de TiN, de Nb ou d'un empilement des deux matériaux. D'autres matériaux supraconducteurs peuvent être envisagés, par exemple le NbN, qui pourrait être utilisé seul, ou en combinaison avec le TiN et/ou avec le Nb.

La structure d'interconnexion comprend également un deuxième trou 29 créé depuis la face avant 3, et qui est creusé sur une partie de la profondeur du substrat (par exemple jusqu'à la moitié de la profondeur). Une deuxième couche supraconductrice 30 est déposée sur les flancs du deuxième trou 29, au fond du trou ainsi que sur une partie de la surface de la face avant. Par exemple, la deuxième couche supraconductrice 30 peut être composée de TiN, de Nb ou d'un empilement des deux matériaux. D'autres matériaux supraconducteurs peuvent être envisagés, par exemple le NbN, qui pourrait être utilisé seul, ou en combinaison avec le TiN et/ou avec le Nb.

Une couche métallique non-supraconductrice 8 recouvre la première couche supraconductrice 31 en tout point, c'est-à-dire au niveau de la face arrière 4, sous la couche de passivation 15, mais également sur les flancs du trou et au fond du trou. Par exemple, la couche métallique non-supraconductrice 8 peut être du cuivre.

Le deuxième mode de réalisation permet de déposer une couche plus épaisse de matériau supraconducteur au fond du premier trou, avec une meilleure conformité pour un dépôt en PVD (car la profondeur du trou est plus faible que pour le premier mode de réalisation). Ainsi, la valeur du courant critique qui peut circuler dans la structure d'interconnexion, qui est proportionnelle à l'épaisseur de matériau supraconducteur, est donc plus élevée qu'avec le premier mode de réalisation.

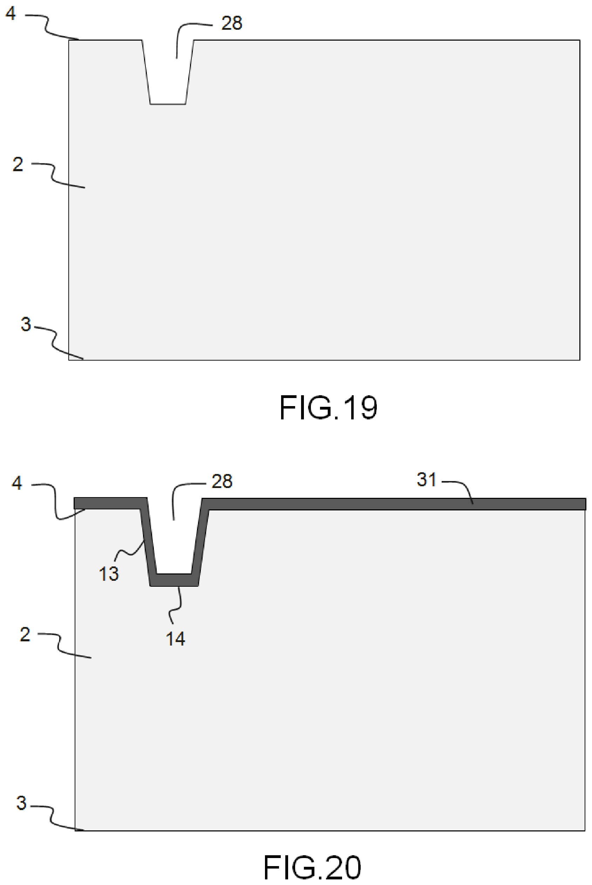

Les figures 19 à 33 illustrent les différentes étapes de la fabrication du système d'interconnexion selon le deuxième mode de réalisation correspondant au schéma de la figure 18.

Le procédé comprend la fourniture d'un substrat 2 définissant une face avant 3 et une face arrière 4 (figure 19 et étape S1, figure 34). La face avant du substrat désigne ainsi la surface sur laquelle sont formés les modules actifs supraconducteurs (par exemple les puces de qubits, ou les pixels d'un capteur), tandis que la face arrière correspond à la face opposée. Un premier trou 28 est aménagé dans le substrat, par la face arrière. Le premier trou 28 peut avoir une profondeur de 60 µm, et un diamètre (au fond du trou) compris entre 40 et 60 µm. La formation du trou est donc moins « agressive » que pour le premier mode de réalisation.

Sur la figure 20, une couche première supraconductrice 31 est déposée au niveau du flanc 13 et au niveau du fond 14 du trou, ainsi que sur la face arrière. Le dépôt peut être effectué par dépôt chimique en phase vapeur (ou CVD pour « Chemical Vapor Deposition ») d'un métal supraconducteur, par exemple du TiN. Le dépôt chimique en phase vapeur peut être combiné à un dépôt physique en phase vapeur (ou PVD pour « Physical Vapor Deposition ») d'un autre matériau supraconducteur, par exemple du niobium. L'épaisseur cible est égale à 200 nm. Les matériaux supraconducteurs et/ou leur technique de dépôt peuvent être sélectionnés et combinés en fonction du niveau de performance requis.

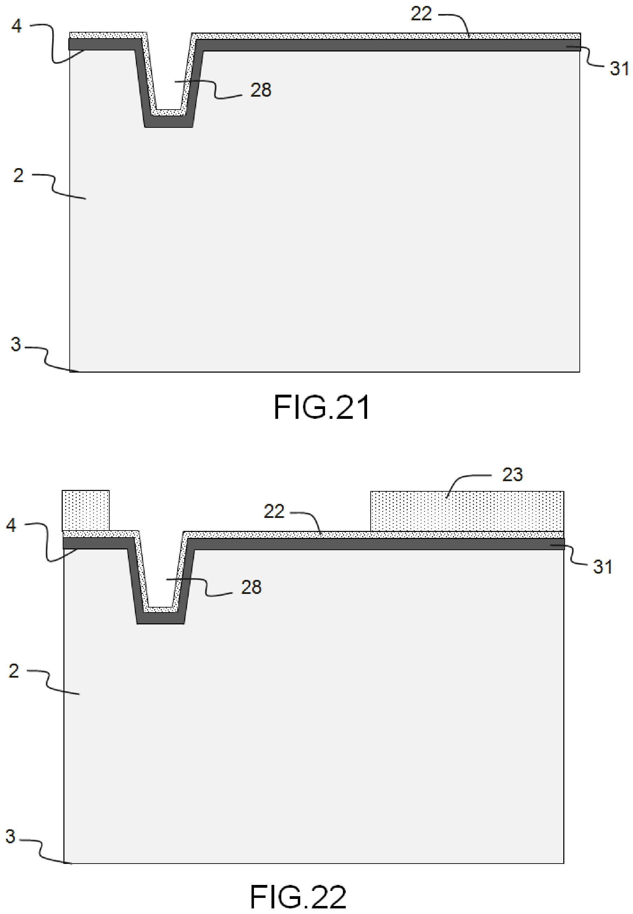

Avantageusement, une couche de construction 22 peut être déposée sur la première couche supraconductrice 31, pour y effectuer une croissance électrolytique (cf. figure 21). Cette couche, également appelée couche de germination, peut être constituée d'un alliage Ti/Cu.

La figure 22 illustre la lithographie de résine sous forme de film sec 23 qui va permettre de faire croitre le cuivre électrolytique dans les zones non protégées par le film 23.

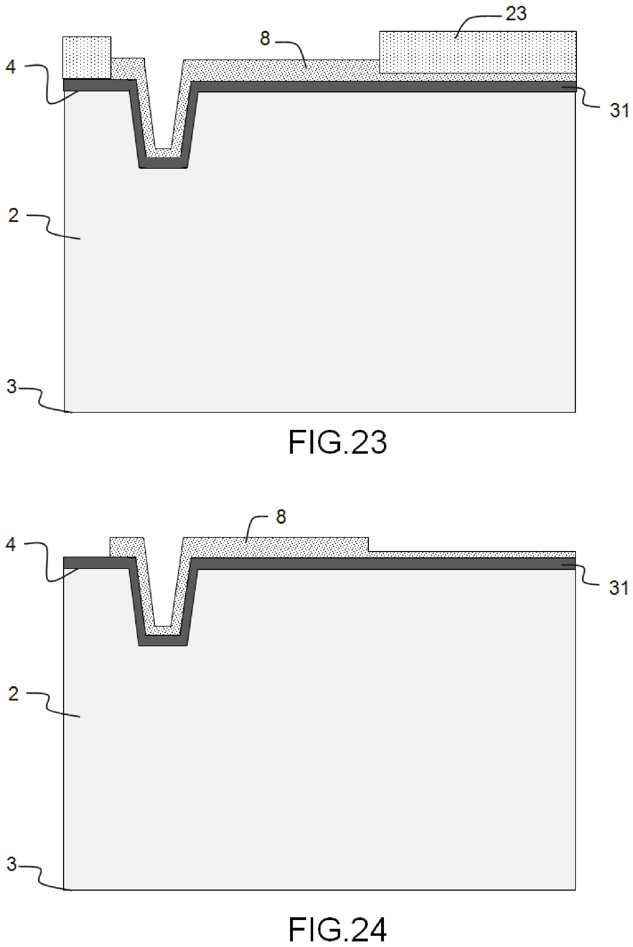

Sur la figure 23, une première couche métallique non-supraconductrice 8, par exemple du cuivre, est déposée sur les flancs du trou, au fond du trou, ainsi que sur la face arrière, à l'exception des emplacements occupés par le film sec 23. La première couche métallique non-supraconductrice 8 peut être déposée, par exemple, par dépôt électrochimique (ou ECD pour « ElectroChemical Deposition »). L'épaisseur cible est égale à 2 µm, voire plus selon la longueur de cohérence du matériau supraconducteur de la couche supraconductrice.

Sur la figure 24, le film sec 23 est retiré par délaquage (« stripping » en anglais).

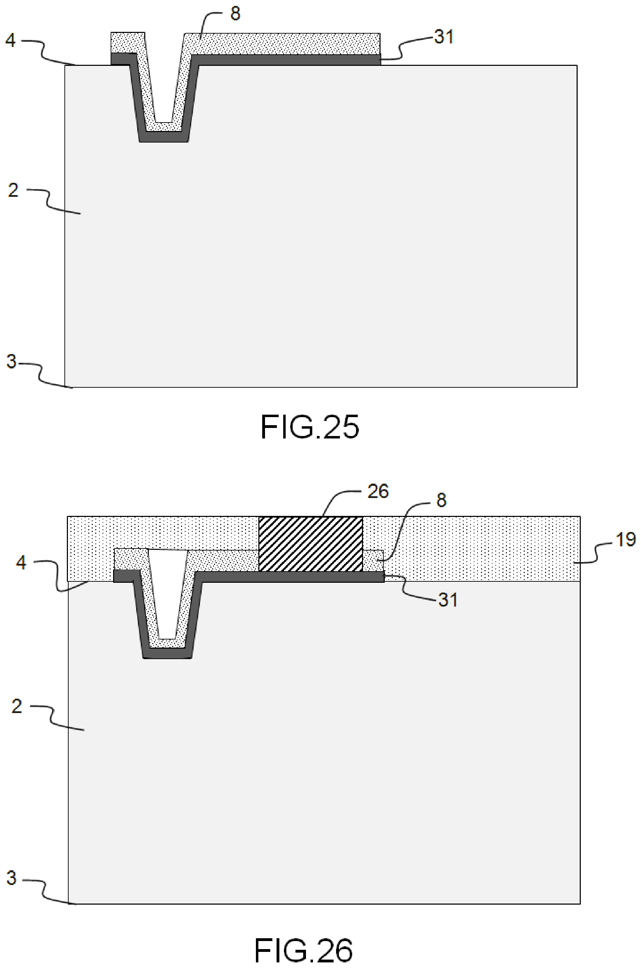

La figure 25 illustre la gravure de la couche de construction 22 puis de la première couche supraconductrice 31. La première couche métallique non-supraconductrice 8 sert ici avantageusement de masque dur pour définir zone de gravure.

La figure 26 illustre une étape de passivation de la face arrière, puis le dépôt d'une métallisation de type UBM 26 La couche de passivation 19 protège la face arrière contre la corrosion (étape S5', figure 34). La métallisation de type UBM 26 sert ici de plot d'entrée des signaux à transmettre à travers le dispositif d'interconnexion.

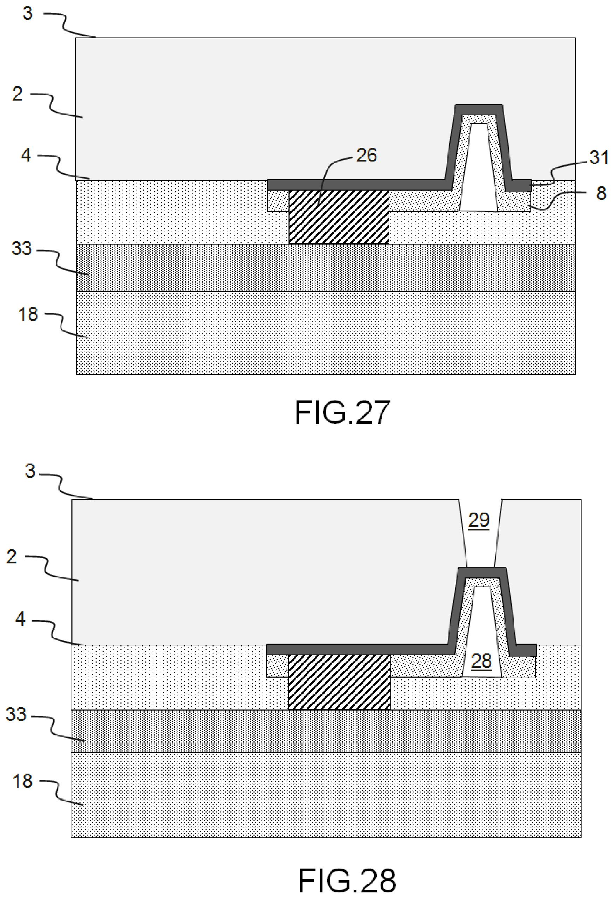

Une première poignée temporaire 18 est ensuite fixée à la couche de passivation 19 par l'intermédiaire d'une couche de colle 33 (étape S6', figure 34), ce qui permet de retourner le dispositif d'interconnexion (figure 27).

Sur la figure 28, un deuxième trou 29 est formé sur la face avant 3 (étape S7', figure 34). Le diamètre du fond du deuxième trou 29 peut avantageusement être inférieur au diamètre du fond du premier trou 28, en particulier avec un écart au plus égal à 10 % du diamètre du premier trou. Par exemple, le deuxième trou 29 peut avoir une profondeur de 60 µm, et un diamètre (au fond du trou) compris entre 30 et 50 µm. Cela permet d'avoir un bon alignement entre le fond du premier trou et le fond du deuxième trou, en garantissant que l'intégralité de la surface du fond du deuxième trou 29 soit en contact avec le fond du premier trou.

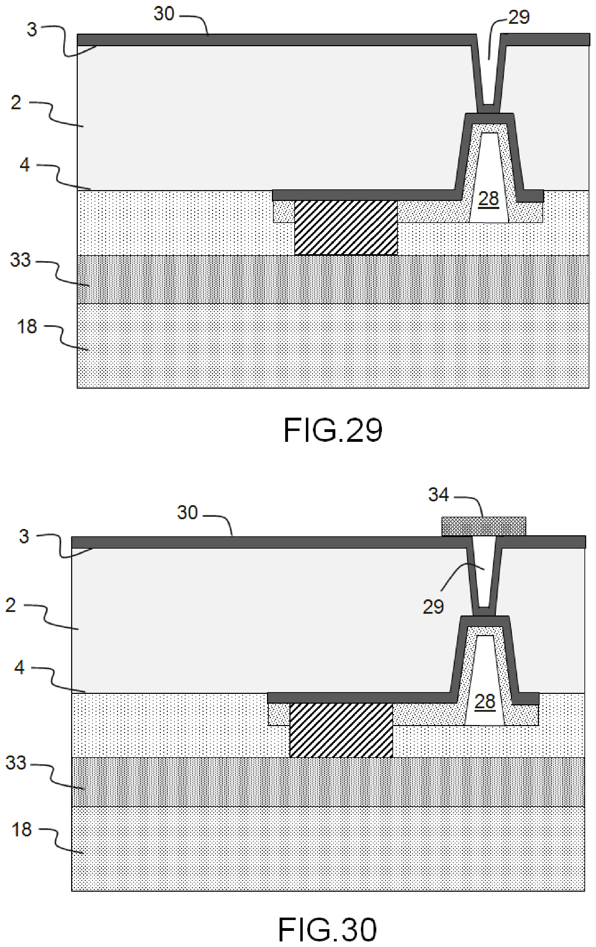

La figure 29 illustre l'étape de métallisation de la face avant avec une deuxième couche supraconductrice 30 (étape S8', figure 34). Cette couche peut être déposée par IBD (« lon Beam Depostion », ou « dépôt par faisceau d'ions »), à une température inférieure à 200 °C.

De façon avantageuse, un opercule de protection 34 est déposé à l'entrée du deuxième trou 29, le matériau de l'opercule de protection pouvant être identique à celui de la couche de passivation 19 (figure 30). L'opercule de protection 34 peut, ainsi, être composé d'un polymère photosensible. L'utilisation d'un opercule de protection évite de mettre en œuvre une étape de lithographie à film sec, dont les performances en résolution (sur la face avant) sont typiquement de l'ordre de 30 µm, alors que les dispositifs à base de jonctions Josephson requièrent une précision de l'ordre du micron.

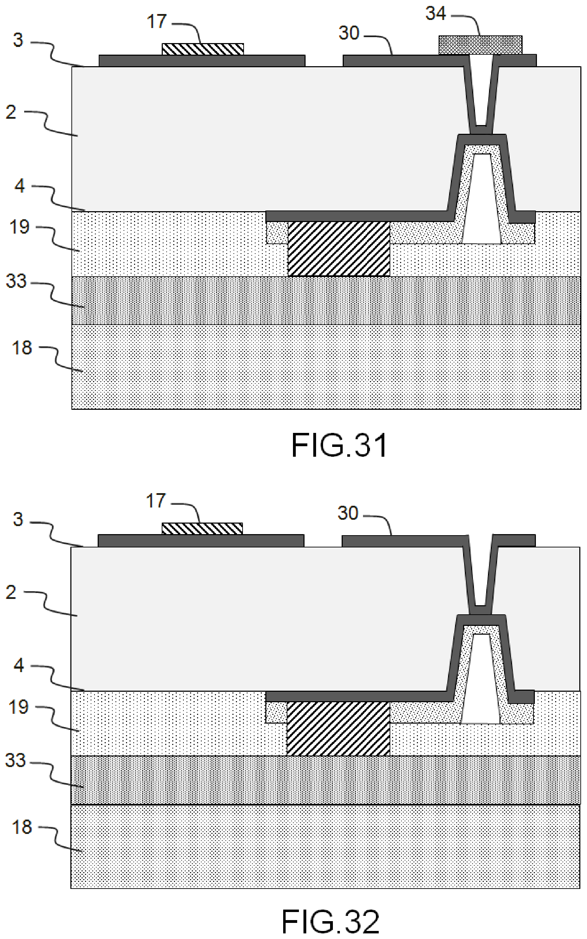

La face avant 3 est ensuite structurée de façon à accueillir au moins un module électronique supraconducteur 17 sur la deuxième couche supraconductrice 30, comme l'illustre la figure 31 (étape S9', figure 34)

L'opercule de protection 34 est ensuite retiré (figure 32), par attaque sèche (« dry etching » en anglais), en veillant à ne pas abimer les dispositifs à base de jonctions Josephson durant l'attaque sèche.

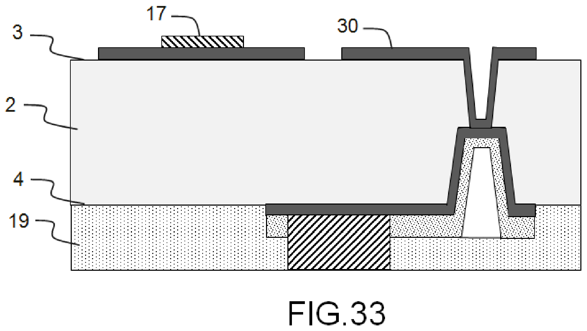

La dernière étape, illustrée par la figure 33, consiste à retirer la première poignée temporaire 18 et la couche de colle 33 (étape S10', figure 34).

### Documents cités

[Vahidpour] « Superconducting Through-Silicon Vias for Quantum Integrated Circuits », Mehrnoosh Vahidpour et al., https://arxiv.org/abs/1708.02226
[Thomas] « Superconducting routing platform for large-scale integration of quantum technologies », Candice THOMAS et al., Mater. Quantum Technol. 2 (2022) 035001

## Revendications

1. Structure d'interconnexion de type via supraconducteur (1), comprenant :
- un substrat (2) définissant une face avant (3) et une face arrière (4) ;
- au moins un trou (5) qui s'étend au moins sur une partie de la profondeur du substrat, depuis une ouverture (6) du côté de la face arrière (4) ;
- une couche supraconductrice (7) qui recouvre au moins une partie du substrat sur la face arrière, ainsi que le trou (5) au niveau du flanc (13) et au niveau du fond (14) du trou (5) ;
la structure d'interconnexion étant **caractérisée en ce qu'**elle comprend également une couche métallique non-supraconductrice (8) qui recouvre la couche supraconductrice (7), l'épaisseur de la couche supraconductrice (7) étant déterminée en fonction des propriétés supraconductrices du couple formé par le matériau de la couche supraconductrice (7) et par le matériau de la couche métallique non-supraconductrice (8), de façon à ce que toute la conduction à travers la structure d'interconnexion se fasse par la couche supraconductrice (7).

2. Structure selon la revendication 1, dans laquelle un plan de routage supraconducteur (9) est déposé sur la face avant (3), le trou (5) s'étendant sur toute la profondeur du substrat (2), jusqu'à atteindre le plan de routage supraconducteur (9), définissant une membrane (10) correspondant à la surface de la couche supraconductrice (7) en contact direct avec le plan de routage supraconducteur (9).

3. Structure selon la revendication 2, dans laquelle le diamètre (d1) de la membrane (10) est inférieur au diamètre (d2) du trou (5) au niveau de la face arrière (4), définissant ainsi une pente ayant un angle prédéterminé (α), l'angle (α) étant défini par rapport à une première droite (11) parallèle à la face avant (3) et à une deuxième droite (12) parallèle au flanc (13).

4. Structure selon la revendication 3, dans laquelle l'angle est compris entre 70° et 80°.

5. Structure selon la revendication 1, comprenant un premier trou (28) et un deuxième trou (29), le premier trou (28) correspondant au trou (5) qui s'étend au moins sur une partie de la profondeur du substrat, depuis une ouverture (6) du côté de la face arrière (4), la couche supraconductrice (7) qui recouvre le premier trou (28) étant appelée « première couche supraconductrice (31) », le deuxième trou (29) s'étendant depuis la face avant, le premier trou (28) et le deuxième trou (29) étant agencés de façon à ce qu'ils soient alignés selon la profondeur du substrat, une deuxième couche supraconductrice (30) recouvrant au moins une partie du substrat sur la face avant, ainsi que le flanc et le fond du deuxième trou (29).

6. Procédé de fabrication d'une structure d'interconnexion de type via supraconducteur, le procédé comprenant des étapes de :
S1 : fourniture d'un substrat (2) définissant une face avant (3) et une face arrière (4) ;
S2 : structuration d'un trou (5) par la face arrière (4) du substrat, au moins sur une partie de la profondeur du substrat (2) ;
S3 : dépôt d'une couche supraconductrice (7) qui recouvre au moins une partie du substrat sur la face arrière, ainsi que le trou (5) au niveau du flanc (13) et au niveau du fond (14) du trou (5) ;
S4 : dépôt d'une couche métallique non-supraconductrice (8) sur la couche supraconductrice (7), l'épaisseur de la couche supraconductrice (7) étant déterminée en fonction des propriétés supraconductrices du couple formé par le matériau de la couche supraconductrice (7) et par le matériau de la couche métallique non-supraconductrice (8), de façon à ce que toute la conduction à travers la structure d'interconnexion se fasse par la couche supraconductrice (7).

7. Procédé selon la revendication 6, comprenant :
- entre les étapes S1 et S2, un dépôt d'un plan de routage supraconducteur (9) sur la face avant, et une étape de collage d'une première poignée temporaire (18) sur le plan de routage supraconducteur (9) ;
- dans l'étape S2, structuration du trou sur toute la profondeur du substrat, jusqu'à ce que le fond (14) du trou débouche sur le plan de routage supraconducteur (9) ;
Le procédé comprenant, à la suite de l'étape S4, les étapes suivantes :
- S5 : passivation de la face arrière (4) de façon à obtenir une couche de passivation (19), et structuration de la face arrière (4) de façon à accueillir au moins un dispositif de connexion électrique (20) ;
- S6 : collage d'une deuxième poignée temporaire (21) sur la couche de passivation (19) ;
- S7 : retrait de la première poignée temporaire (18) ;
- S8 : structuration de la face avant (3) de façon à accueillir au moins un module électronique supraconducteur (17) sur le plan de routage supraconducteur (9) ;
- S9 : retrait de la deuxième poignée temporaire (21).

8. Procédé selon l'une des revendications 6 ou 7, comprenant, entre les étapes S3 et S4, une étape de dépôt d'une couche de construction (22) sur la couche supraconductrice (7), pour y effectuer une croissance électrolytique.

9. Procédé selon l'une des revendications 6 à 8, dans lequel l'étape S3 comprend un dépôt électrochimique de la couche métallique non-supraconductrice (8).

10. Procédé selon l'une des revendications 6 à 9, dans lequel la couche métallique non-supraconductrice (8) est utilisée comme masque dur dans une étape de gravure de la face arrière, entre les étapes S4 et S5.

11. Procédé selon l'une des revendications 7 à 10, dans lequel la première poignée temporaire (18) est collée par collage moléculaire, la première poignée temporaire (18) étant retirée par abrasion puis par gravure humide avec arrêt sélectif au niveau du plan de routage supraconducteur (9).

12. Procédé selon l'une des revendications 7 à **11,** dans lequel la deuxième poignée temporaire (21) est collée avec une colle polymère, la deuxième poignée temporaire (21) étant retirée par décollement mécanique ou par traitement UV.

13. Procédé selon la revendication 6, comprenant :
- dans l'étape S2, une structuration du trou sur une partie de la profondeur du substrat, le trou étant appelé « premier trou » (28) ;
le procédé comprenant, à la suite de l'étape S4, les étapes suivantes :
- S5' : dépôt d'une couche de passivation sur la face arrière ;
- S6' : collage d'une poignée temporaire (18) sur la couche de passivation (19) ;
- S7' : structuration d'un deuxième trou(29) par la face avant du substrat, le premier trou (28) et le deuxième trou (29) étant agencés de façon à ce qu'ils soient alignés selon la profondeur du substrat ;
- S8' : métallisation de la face avant et du deuxième trou (29), avec une deuxième couche supraconductrice (30) ;
- S9' : structuration de la face avant de façon à accueillir au moins un module électronique supraconducteur (17) ;
- S10' : retrait de la poignée temporaire (18).

14. Procédé selon la revendication 13, dans lequel la profondeur du premier trou (28) et la profondeur du deuxième trou (29) sont identiques.

15. Procédé selon l'une des revendications 13 ou 14, dans lequel le diamètre du fond du deuxième trou (29) est inférieur au diamètre du fond du premier trou (28).

16. Procédé selon l'une des revendications 13 à 15, comprenant, entre les étapes S8' et S9', une étape S10' de dépôt d'un opercule de protection (34) à l'entrée du deuxième trou (29).
